# EUROPEAN PATENT SPECIFICATION

(11) **EP 4 020 039 B1**
(45) Date of publication and mention of the grant of the patent: **09.07.2025**
(21) Application number: 21197529.7
(22) Date of filing: 17.09.2021
(51) Int. Cl.: G02B 6/42

(54) **WAVEGUIDE WITH SELF-ALIGNED MIRROR IN PACKAGE FOR LONG RANGE CHIP-TO-CHIP COMMUNICATIONS**
WELLENLEITER MIT SELBSTAUSRICHTENDEM SPIEGEL IN EINEM GEHÄUSE FÜR CHIP-ZU-CHIP-KOMMUNIKATIONEN MIT GROSSER REICHWEITE
GUIDE D'ONDES AVEC MIROIR AUTO-ALIGNÉ DANS UN BOÎTIER POUR DES COMMUNICATIONS LONGUE PORTÉE DE PUCE À PUCE

(30) Priority: 22.12.2020 US 202017131678
(43) Date of publication of application: 29.06.2022
(73) Proprietor: INTEL Corporation, Santa Clara, CA 95054 (US)
(72) Inventor: ALEKSOV, Aleksandar, Chandler, 85286 (US); MARIN, Brandon, Gilbert, 85234 (US); PIETAMBARAM, Srinivas, Chandler, 85297 (US); ZHANG, Zhichao, Chandler, 85286 (US); DUAN, Gang, Chandler, 85248 (US); ECTON, Jeremy, Gilbert, 85298 (US); TANAKA, Hiroki, Gilbert, 85295 (US); VADLAMANI, Sai, Chandler, 85226 (US); NIE, Bai, Chandler, 85249 (US); CHEN, Haobo, Chandler, 85249 (US)
(74) Representative: HGF

(56) References cited:
- WO-A1-2009/096981
- CN-A- 101 344 624
- KR-B1- 100 834 648
- US-A1- 2003 228 084
- US-A1- 2010 272 388
- US-A1- 2016 356 961

## Description

### TECHNICAL FIELD

The present disclosure relates to electronic packaging systems, and more particularly to optical waveguide architectures to provide chip-to-chip communications.

### BACKGROUND

With data rate increases over time, electrical interconnects cannot keep up with the energy efficiency requirements for sustained bandwidth. Optical interconnect architectures demonstrate unparalleled long distance signaling capability. As such the transition from electrical to optical interconnects has already begun, especially for long distance communications.

Integrated waveguides in the package substrate are a promising approach for low cost methods to enable fast and long range transmission of signals within the package. However, methods for efficiently routing signals within the in-package waveguide are lacking. In particular, significant optical losses are observed due to alignment offset created as a result of multiple patterning operations required to route the waveguide signal within the package. US 2010/0272388 A1 discloses a photoelectric conversion module in which an optical device and an optical waveguide are arrayed in a horizontal direction. CN 101344624 A discloses an optoelectronic hybrid printed circuit board provided with an inter-chip optical interconnection direct-coupling structure. US 2003/0228084 A1 discloses a method and device for enhancing laser beam transmitting efficiency by accurately controlling an interval between a light emitting element and an optical waveguide substrate without causing any fluctuation in the interval in a mounting structure of the light transmitting element in which the light emitting element is mounted on the optical waveguide substrate. US 2016/0356961 A1 discloses an embedded optical fiber module adapted to fit in a recess of a package substrate. KR 100834648 B1 discloses a photoelectric hybrid substrate and a manufacturing method thereof to minimize an error generated by shrinkage in aligning an optical axis.

### BRIEF DESCRIPTION OF THE DRAWINGS

Figure 1A is a cross-sectional illustration of an electronic system with an optical waveguide embedded in the package substrate, not in accordance with an embodiment.
Figure 1B is a cross-sectional illustration of an electronic system with an optical waveguide over the package substrate, not in accordance with an embodiment.
Figure 2A is a cross-sectional illustration of an electronic package with an embedded waveguide with a first sloped end and a second sloped end, not in accordance with an embodiment.
Figure 2B is a cross-sectional illustration of an electronic package with an embedded waveguide with a first sloped end and a second end at the edge of the package substrate, not in accordance with an embodiment.
Figures 3A-3F are cross-sectional illustrations depicting a process for forming an embedded waveguide, not in accordance with an embodiment.
Figure 4A is a cross-sectional illustration of an electronic package with a waveguide over the package substrate, in accordance with an embodiment.
Figure 4B is a cross-sectional illustration of an electronic package with a waveguide over the package substrate and an end at the edge of the package substrate, not in accordance with an embodiment.
Figures 5A-5D are cross-sectional illustrations depicting a process for forming a waveguide over a package substrate, not in accordance with an embodiment.
Figure 6A is a cross-sectional illustration of an embedded waveguide with a reflective cladding, not in accordance with an embodiment.
Figure 6B is a cross-sectional illustration of an embedded waveguide with a reflective cladding that has an end at the edge of the package substrate, not in accordance with an embodiment.
Figures 7A-7C are cross-sectional illustrations depicting a process for forming a waveguide in a package substrate, not in accordance with an embodiment.
Figure 8A is a cross-sectional illustration of an embedded waveguide with reflective structures at opposite ends of the waveguide, in accordance with an embodiment of the claimed invention.
Figure 8B is a cross-sectional illustration of an embedded waveguide with a reflective structure at a first end and a second end at an edge of the package substrate, in accordance with an embodiment of the claimed invention.
Figures 9A-9I are cross-sectional illustrations depicting a process for forming an embedded waveguide with first and second reflective structures, in accordance with an embodiment of the claimed invention.
Figure 10A is a cross-sectional illustration of an embedded waveguide with reflective structures on opposite ends and a reflective cladding, in accordance with an embodiment of the claimed invention.
Figure 10B is a cross-sectional illustration of an embedded waveguide with a reflective structure at one end and a second end at an edge of the package substrate, in accordance with an embodiment of the claimed invention.
Figures 11A-11F are cross-sectional illustrations depicting a process for forming an embedded waveguide with reflective structures and a reflective cladding, in accordance with an embodiment of the claimed invention.
Figure 12A is a cross-sectional illustration of an embedded waveguide with a first reflective structure and a second reflective structure, in accordance with an embodiment of the claimed invention.
Figure 12B is a cross-sectional illustration of an embedded waveguide with a reflective structure at a first end and a second end at an edge of the package substrate, not in accordance with an embodiment.
Figures 13A-13H are cross-sectional illustrations depicting a process for forming an embedded waveguide with a first reflective structure and a second reflective structure, not in accordance with an embodiment.
Figure 14A is a cross-sectional illustration of an embedded waveguide with a reflective cladding, not in accordance with an embodiment.
Figure 14B is a cross-sectional illustration of an embedded waveguide with a reflective cladding that ends at an edge of the package substrate, not in accordance with an embodiment.
Figures 15A-15F are cross-sectional illustrations depicting a process for forming an embedded waveguide, not in accordance with an embodiment.
Figure 16A is a plan view illustration of an array of optical waveguides in a package substrate, not in accordance with an embodiment.
Figure 16B is a plan view illustration of a waveguide plane in a package substrate, not in accordance with an embodiment.
Figure 17 is a schematic of a computing device built not in accordance with an embodiment.

### EMBODIMENTS OF THE PRESENT DISCLOSURE

Described herein are optical waveguide architectures to provide chip-to-chip communications, in accordance with various embodiments. In the following description, various aspects of the illustrative implementations will be described using terms commonly employed by those skilled in the art to convey the substance of their work to others skilled in the art. However, it will be apparent to those skilled in the art that the present invention may be practiced with only some of the described aspects. For purposes of explanation, specific numbers, materials and configurations are set forth in order to provide a thorough understanding of the illustrative implementations. However, it will be apparent to one skilled in the art that the present invention may be practiced without the specific details. In other instances, well-known features are omitted or simplified in order not to obscure the illustrative implementations.

Various operations will be described as multiple discrete operations, in turn, in a manner that is most helpful in understanding the present invention, however, the order of description should not be construed to imply that these operations are necessarily order dependent. In particular, these operations need not be performed in the order of presentation.

As noted above, embedded optical waveguides within a package substrate currently have significant optical losses due to alignment offsets created as a result of multiple patterning operations. Accordingly, embodiments disclosed herein include self-aligned reflective surfaces on opposite ends of the optical waveguide. In an embodiment, the optical waveguide provides a lateral path for routing signals, and the reflective surfaces allow for coupling with dies positioned above the package substrate. Due to the self-aligned nature of the reflective surfaces, optical losses are minimized.

In some embodiments, the optical waveguide is over the package substrate. That is, the optical waveguide may be between the dies and the package substrate. In other embodiments, the optical waveguide is at least partially embedded in the package substrate. At least partially embedded may refer to a waveguide that has a bottom surface and sidewall surfaces covered by the package substrate, while a top surface of the waveguide is exposed to the atmosphere. In yet another embodiment, the optical waveguide is fully embedded in the package substrate, so that all surfaces along a length of the waveguide are covered by the package substrate.

In an embodiment, the waveguides may comprise a high index of refraction material. For example, the index of refraction may be greater than 1.0. In other embodiments, the waveguides may comprise air. For example, a reflective cladding may surround a void in the package substrate, and the optical signal propagates through the void without any solid material along the optical path.

In an embodiment, the reflective surfaces may be part of the optical waveguide. For example, differences in index of refraction may allow for a complete reflection of the signal at the ends of the waveguide. In other embodiments, reflective structures are provided at the ends of the waveguide. The reflective structures may have unique structures due to the self-aligned process. For example, the reflective structures comprise trapezoidal shaped cross-sections with a triangular notch along a bottom surface. In other embodiments not according to the claimed invention, the reflective structures may comprise parallelogram shaped cross-sections.

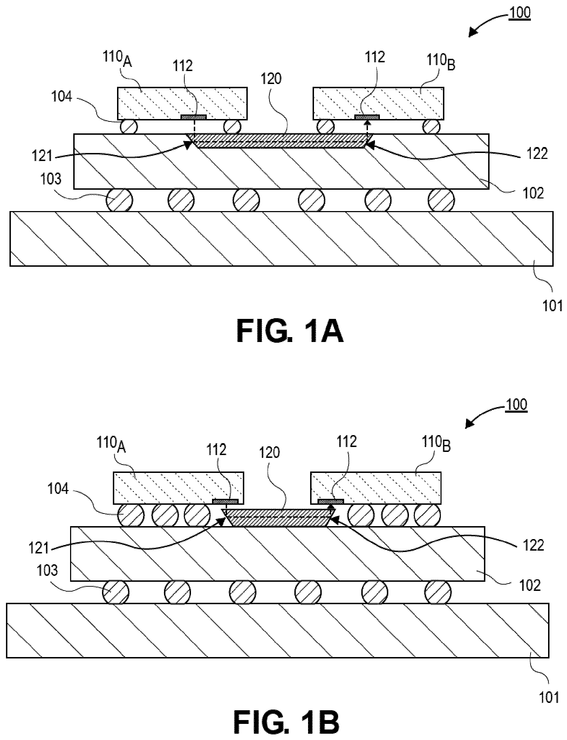

Referring now to Figure 1A, a cross-sectional illustration of an electronic system 100 is shown, not in accordance with an embodiment. In this embodiment, the electronic system 100 may comprise a board 101 (such as a printed circuit board (PCB). A package substrate 102 is coupled to the board by interconnects 103. While shown as solder balls, it is to be appreciated that the interconnects 103 may comprise any interconnect architecture, such as sockets or the like. In an embodiment, a pair of dies 110_{A} and 110_{B} are provided over the package substrate 102. First level interconnects (FLIs) 104 may couple the package substrate 102 to the dies 110_{A} and 110_{B}.

In an embodiment, an optical waveguide 120 (sometimes referred to as simply "waveguide 120") is at least partially embedded in the package substrate 102. The waveguide 120 comprises a first end 121 and a second end 122. The first end 121 is provided below the first die 110_{A} and the second end 122 is provided below the second die 110_{B}. In an embodiment, photonics regions 112 on the first die 110_{A} and the second die 110_{B} are directly over the first end 121 and the second end 122 of the waveguide 120. As such, an optical signal (represented by the dashed line) can be sent between the first die 110_{A} and the second die 110_{B}.

In an embodiment, the first end 121 and the second end 122 have sloped surfaces. As such, the direction of the optical signal can be changed from vertical to horizontal. In an embodiment, the sloped surfaces are approximately 45°, though it is to be appreciated that other angles may also be used. The reflection of the first end 121 and the second end 122 may be the result of mismatches in the index of refraction between the waveguide 120 and the package substrate 102. For example, a material with an index of refraction greater than that of the package substrate may be used in order to provide total internal reflection at the first end 121 and the second end 122. In other embodiments (as will be described in greater detail below) the reflection at the first end 121 and the second end 122 may be made by reflective structures that are self-aligned to the waveguide 120.

Referring now to Figure 1B, a cross-sectional illustration of an electronic system 100 is shown, not in accordance with an additional embodiment. The electronic system 100 may be substantially similar to the electronic system 100 described in Figure 1A, with the exception of the placement of the waveguide 120. Instead of being embedded in the package substrate 102, the waveguide 120 is provided between the dies 110_{A} and 110_{B} and the package substrate 102. In such an embodiment, the waveguide 120 comprises an index of refraction material that is higher than air in order to provide the total internal reflection needed to rout optical signals from the first die 110_{A} to the second die 110_{B}.

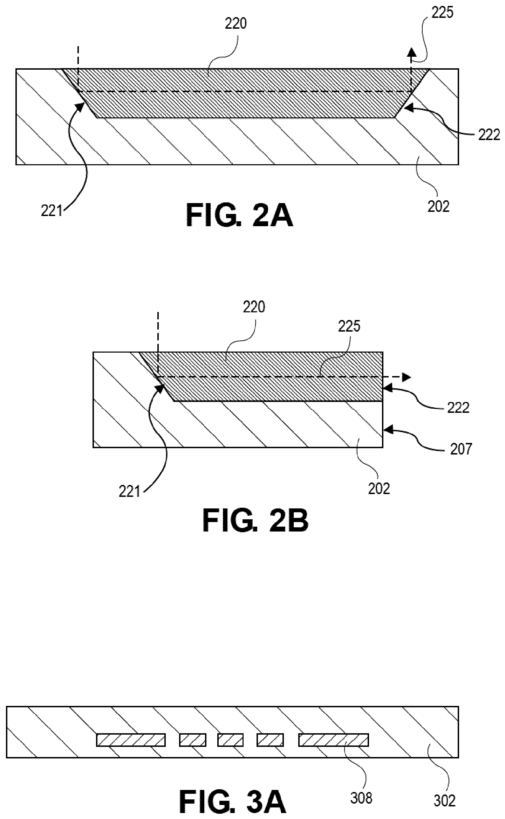

Referring now to Figure 2A, a cross-sectional illustration of an optical waveguide 220 partially embedded in a package substrate 202 is shown, not in accordance with an embodiment. The waveguide 220 may have a bottom surface and sidewall surfaces that are contacted by the package substrate 202. A top surface of the waveguide 220 may be exposed to the atmosphere. In an embodiment, the optical waveguide 220 comprises a high index of refraction material, such as high index polymers or dielectrics. Particularly, the index of refraction of the waveguide 220 is higher than the index of refraction of the surrounding package substrate 202 and atmosphere.

Due to the differences in the index of refraction, total internal reflection is provided when an optical signal 225 reaches the first end 221 and the second end 222 of the waveguide 220. The waveguide 220 may be patterned with an angled patterning process. As such, the first end 221 and the second end 222 may be sloped in order to redirect the optical signal 225 vertically to allow communication between overlying dies (not shown). Since the first end 221 and the second end 222 are patterned during the patterning to form the waveguide 220, the first end 221 and the second end 222 may be referred to as being self-aligned. A more detailed description of the angled patterning process is provided below.

Referring now to Figure 2B, a cross-sectional illustration of an optical waveguide 220 in a package substrate 202 is shown, not in accordance with an additional embodiment. The optical waveguide 220 may comprise a first end 221 that is sloped and a second end 222 that is vertical. The second end 222 may be substantially coplanar with an edge 207 of the package substrate 202. In such an embodiment, the optical signal 225 may be routed off the package substrate 202 to another device. In an embodiment, the materials for the optical waveguide 220 and package substrate 202 in Figure 2B may be substantially similar to those described above with respect to Figure 2A.

Referring now to Figures 3A-3F, a series of cross-sectional illustrations depicting a process for forming an embedded waveguide similar to the one shown in Figure 2A is shown, not in accordance with an embodiment.

Referring now to Figure 3A, a cross-sectional illustration of a package substrate 302 is shown, not in accordance with an embodiment. The package substrate 302 may comprise a plurality of laminated dielectric layers with conductive routing 308. The package substrate 302 may be cored or coreless. While a single layer of conductive routing 308 is shown, it is to be appreciated that a plurality of conductive routing, vias, pads, etc. may be provided in the package substrate 302.

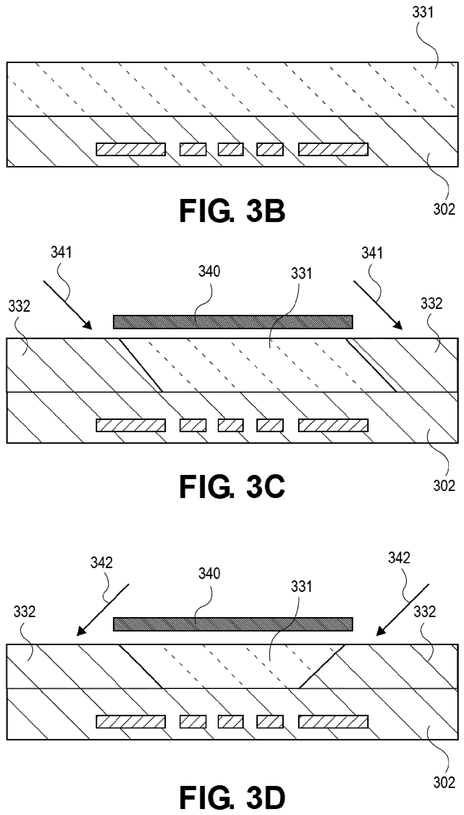

Referring now to Figure 3B, a cross-sectional illustration of the package substrate 302 after a photo-imageable dielectric (PID) 331 is disposed over the package substrate 302 is shown, in accordance with an embodiment. The PID 331 may be disposed with any suitable process, such as lamination.

Referring now to Figure 3C, a cross-sectional illustration of the package substrate 302 after a first exposure is shown, not in accordance with an embodiment. In an embodiment, a mask 340 may be used to cover a portion of the PID 331. A first exposure 341 is used to expose portions of the PID 331 to form exposed PID 332. The first exposure 341 may be an angled exposure. As such, the unexposed portion of the PID 331 may have a parallelogram shape.

Referring now to Figure 3D, a cross-sectional illustration of the package substrate 302 after a second exposure is shown, not in accordance with an embodiment. In an embodiment, the second exposure 342 may be done at an angle that mirrors the angle of the first exposure 341. As a result, the unexposed portions of the PID 331 may have a trapezoidal shape. It is to be appreciated that while two different exposures are made of the PID 331, the mask 340 may not move between the different exposures.

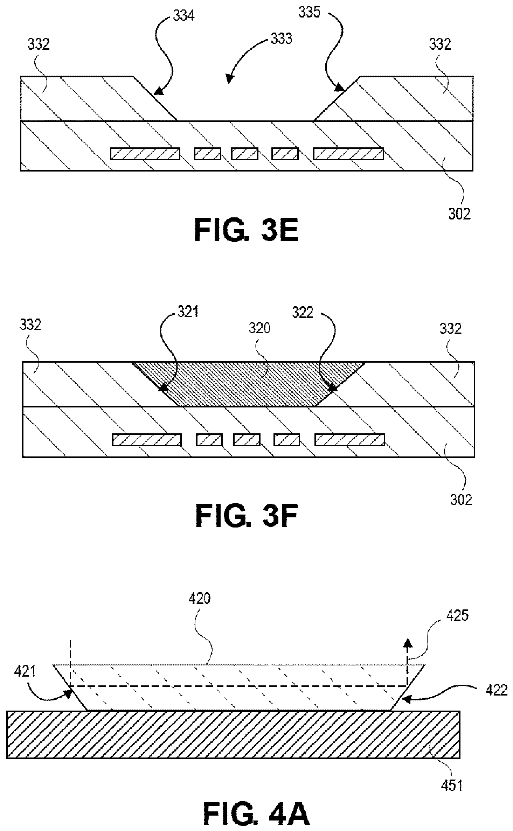

Referring now to Figure 3E, a cross-sectional illustration of the package substrate 302 after the unexposed portions of the PID 331 are removed is shown, not in accordance with an embodiment. In this embodiment, the unexposed portions may be removed with a developing process to form a trench 333. Removal of the unexposed portions of the PID 331 results in the exposure of a first sloped surface 334 and a second sloped surface 335 at opposite ends of the trench 333.

Referring now to Figure 3F, a cross-sectional illustration of the package substrate 302 after an optical waveguide 320 is disposed into the trench 333 is shown, not in accordance with an embodiment. In an embodiment, the optical waveguide 320 comprises a high index of refraction material. Particularly, the index of refraction of the optical waveguide 320 is higher than the index of refraction of the PID 332 and the package substrate 302. The optical waveguide 320 comprises a first end 321 over the surface 334 and a second end 322 over the surface 335.

Referring now to Figure 4A, a cross-sectional illustration of an optical waveguide 420 that is disposed over a package substrate is shown, not in accordance with an embodiment. In an embodiment, a layer 451 with a low index of refraction material is provided under the waveguide 420. The layer 451 may be disposed over the package substrate (not shown). For example, the layer 451 may comprise SiO₂ or SiN in some embodiments.

In an embodiment, the waveguide 420 comprises a high index of refraction material. As such, an optical signal 425 can be retained within the waveguide 420 using total internal reflection. In a particular embodiment, the waveguide 420 is a developed PID material. That is, the waveguide 420 may be the result of a patterning process. The optical signal 425 may reflect off of a first end 421 and a second end 422 in order to rout the optical signal 425 vertically to overlying dies (not shown).

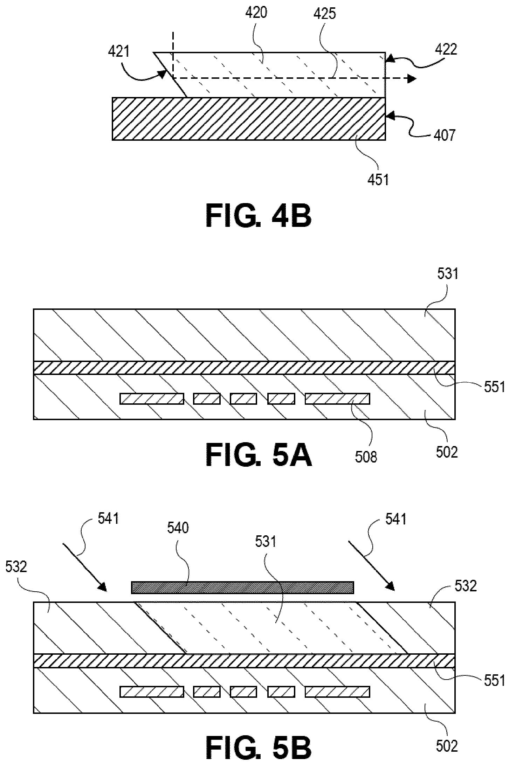

Referring now to Figure 4B, a cross-sectional illustration of an optical waveguide 420 is shown, not in accordance with an additional embodiment. In an embodiment, the optical waveguide 420 includes a first end 421 that is sloped and a second end 422 that is vertical. The second end 422 may be substantially coplanar with an edge 407 of the layer 451 (and the package substrate (not shown)). Similar to the embodiment in Figure 4A, the optical waveguide 420 is provided above the package substrate instead of being embedded in the package substrate. The materials of the optical waveguide 420 and the layer 451 in Figure 4B may be substantially similar to the materials described above with respect to Figure 4A.

Referring now to Figures 5A-5D, a series of cross-sectional illustrations depicting a process for forming an optical waveguide on a package substrate 502 is shown, not in accordance with an embodiment.

Referring now to Figure 5A, a cross-sectional illustration of a package substrate 502 is shown, not in accordance with an embodiment. In this embodiment, the package substrate 502 may be substantially similar to the package substrate 302 described above. For example, the package substrate 502 may comprise dielectric layers with conductive routing 508. In an embodiment, a layer 551 with a low refractive index is provided over the package substrate 502. For example, the layer 551 may comprise SiO₂ or SiN. The layer 551 may be deposited with a sputtering process, or any other suitable material deposition process. In an embodiment, a PID 531 is provided over the layer 551. The PID 531 may be a positive resist material. That is, exposed regions of the PID 531 will be developed away.

Referring now to Figure 5B, a cross-sectional illustration of the package substrate 502 after a first exposure is shown, not in accordance with an embodiment. In an embodiment, a mask 540 may be used to cover a portion of the PID 531. A first exposure 541 is used to expose portions of the PID 531 to form exposed PID 532. The first exposure 541 may be an angled exposure. As such, the unexposed portion of the PID 531 may have a parallelogram shape.

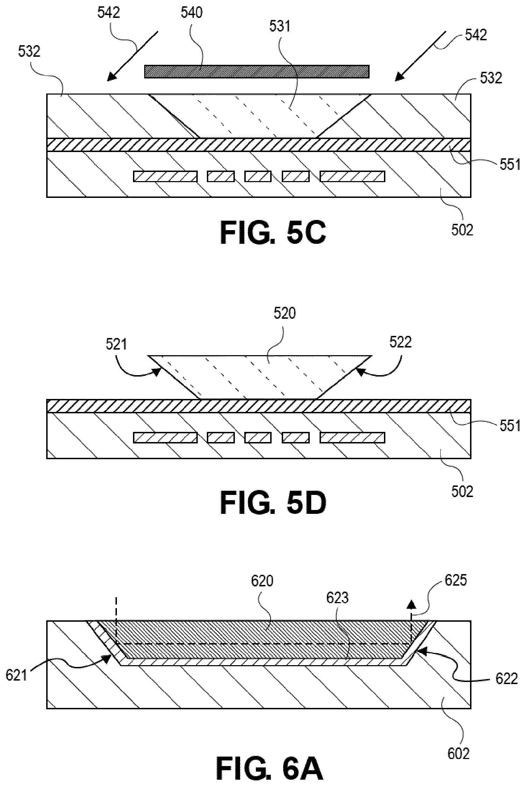

Referring now to Figure 5C, a cross-sectional illustration of the package substrate 502 after a second exposure is shown, not in accordance with an embodiment. In an embodiment, the second exposure 542 may be done at an angle that mirrors the angle of the first exposure 541. As a result, the unexposed portions of the PID 531 may have a trapezoidal shape. It is to be appreciated that while two different exposures are made of the PID 531, the mask 540 may not move between the different exposures.

Referring now to Figure 5D, a cross-sectional illustration of the package substrate 502 after the exposed portions of the PID 532 are developed and removed is shown, not in accordance with an embodiment. As shown, the residual portions of the unexposed PID 531 have a trapezoidal shape that can be used as an optical waveguide 520. The waveguide 520 comprises a first end 521 with a sloped surface and a second end 522 with a sloped surface.

Referring now to Figure 6A, a cross-sectional illustration of an optical waveguide 620 in a package substrate 602 is shown, not in accordance with an additional embodiment. In an embodiment, the waveguide 620 may include a reflective cladding 623. The reflective cladding 623 may be provided between a low loss material of the waveguide 620 and the package substrate 602. The use of a reflective cladding 623 allows for lower index of refraction materials to be used for the waveguide 620. Instead of providing an index of refraction that is higher than that of the package substrate 602, all that is required is that the index of refraction be higher than that of the atmosphere (e.g., greater than approximately 1.0). As such, the material for the waveguide may be selected based on loss characteristics. For example, the material of the waveguide 620 may be a dielectric without any fillers.

In this embodiment, the reflective cladding 623 may be provided over a bottom surface of the waveguide 620 and over the first end 621 and the second end 622. As such, an incoming optical signal 625 may be propagated through the waveguide 620 by reflecting off of the reflective cladding 623 on the first end 621 and the second end 622. In an embodiment, the reflective cladding 623 may comprise a thin, smooth layer, such as a material deposited with an electroless plating process or a liquid metal ink (LMI) process. For example, the reflective cladding 623 may comprise copper, gold, silver, palladium, or the like.

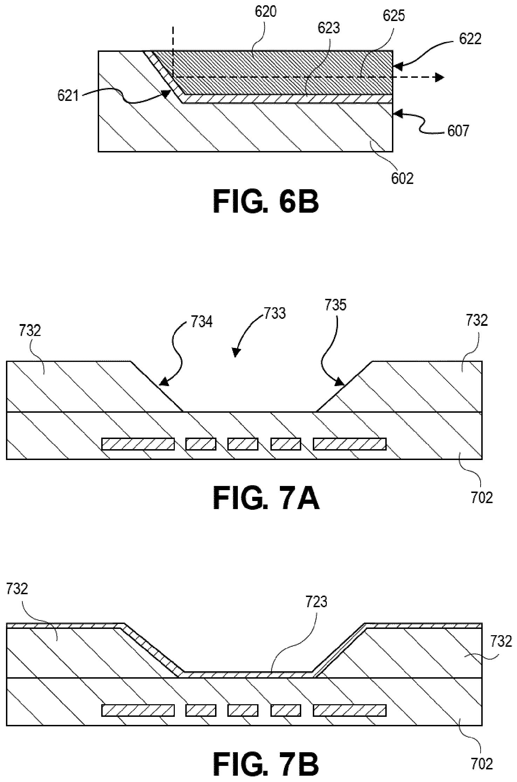

Referring now to Figure 6B, a cross-sectional illustration of an optical waveguide 620 on a package substrate 602 is shown, not in accordance with an additional embodiment. In this embodiment, the optical waveguide 620 comprises a reflective cladding 623 between the optical waveguide 620 and the package substrate 602. In an embodiment, a first end 621 has a sloped surface and a second end 622 has a vertical surface. The second end 622 may be substantially coplanar with an edge 607 of the package substrate 602. In an embodiment, the materials of the optical waveguide 620 and the reflective cladding 623 may be substantially similar to those described above with respect to Figure 6A.

Referring now to Figures 7A-7C, a series of cross-sectional illustrations depicting a process for forming an optical waveguide in a package substrate is shown, not in accordance with an embodiment.

Referring now to Figure 7A, a cross-sectional illustration of a package substrate 702 is shown, not in accordance with an embodiment. In an embodiment, the processing to get to the structure shown in Figure 7A may be substantially similar to the processing operations described above in Figures 3A-3E, and will not be repeated here. Particularly, an angled patterning process is used to form a PID 732 with a trench 733. The trench 733 may comprise a first sloped sidewall 734 and a second sloped sidewall 735.

Referring now to Figure 7B, a cross-sectional illustration of the package substrate 702 after a reflective cladding 723 is deposited is shown, not in accordance with an embodiment. In this embodiment, the reflective cladding 723 may be deposited with an electroless plating process or any other conformal deposition process that can provide a smooth surface. In an embodiment, the reflective cladding 723 may comprise copper, gold, silver, palladium, or the like.

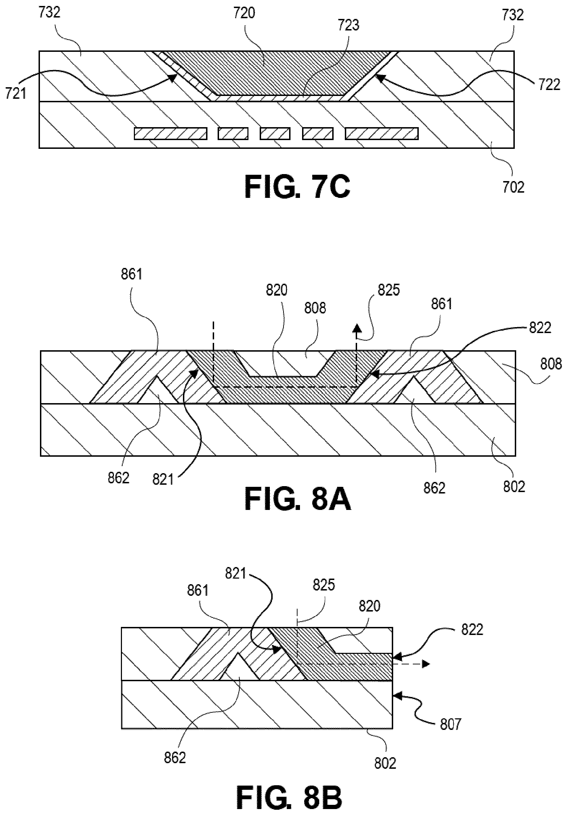

Referring now to Figure 7C, a cross-sectional illustration of the package substrate 702 after a waveguide 720 is disposed in the trench 733 is shown, not in accordance with an embodiment. In an embodiment, the waveguide 720 has a first end 721 and a second end 722. The first end 721 and the second end 722 are sloped surfaces in order to allow for the optical signal to be routed vertically to overlying dies (not shown).

Referring now to Figure 8A, a cross-sectional illustration of an optical waveguide 820 in a package substrate 802 is shown, in accordance with an embodiment of the claimed invention. In this embodiment, the optical waveguide 820 comprises a first end 821 and a second end 822. The first end 821 and the second end 822 may be adjacent to reflective structures 861. The optical signal 825 reflects off of the reflective structures 861 to be routed to overlying dies (not shown). In an embodiment, the optical waveguide 820 may comprise a material with a high index of refraction, such as materials described above.

In an embodiment, the waveguide 820 is fully embedded in the package substrate 802. Particularly, a dielectric layer 808 is disposed over a top surface of the waveguide 820. That is, dielectric material from the package substrate 802 and the dielectric layer 808 may be provided over the bottom surface and a portion of the top surface of the waveguide 620. Accordingly, embodiments may include burying the waveguide 820 in any layer of the package substrate 802.

In this embodiment, the reflective structures 861 have trapezoidal shaped cross-sections with a triangular notch 862 on a bottom surface. The notch 862 may be filled by dielectric material, or may remain as a void in the package. The novel shape of the reflective structures 861 are a result of patterning processes, which will be described in greater detail below. The reflective structures 861 may be copper or other reflective material.

Referring now to Figure 8B, a cross-sectional illustration of an optical waveguide 820 on a package substrate 802 is shown, in accordance with an embodiment. In this embodiment, the waveguide 820 comprises a first end 821 and a second end 822. The first end 821 is adjacent to a reflective structure 861 and the second end 822 is substantially coplanar with an edge 807 of the package substrate 802. In an embodiment, the reflective structure 861 may be substantially similar to the reflective structures described above in Figure 8A. The waveguide 820 may comprise a material with a high index of refraction.

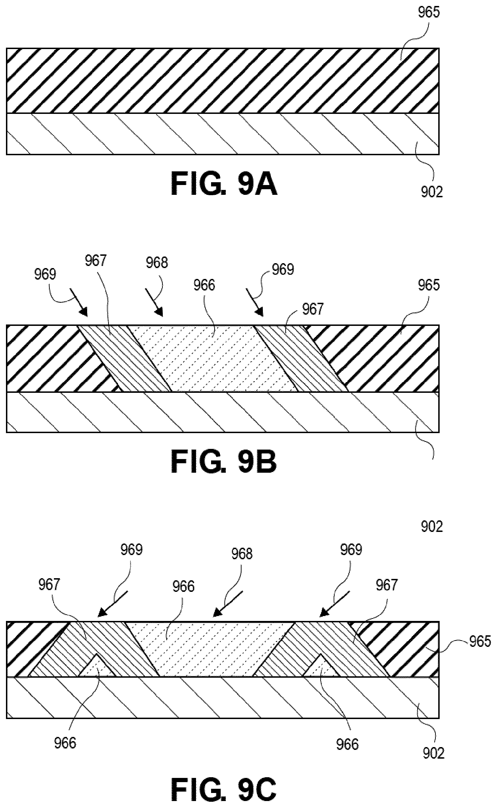

Referring now to Figures 9A-9I a series of cross-sectional illustrations depicting a process for forming an optical waveguide in a package substrate 902 is shown, in accordance with an embodiment.

Referring now to Figure 9A, a cross-sectional illustration of a package substrate 902 with a positive resist layer 965 is shown, in accordance with an embodiment. In this embodiment, the resist layer 965 may be deposited with any suitable deposition process.

Referring now to Figure 9B, a cross-sectional illustration of the package substrate after a first exposure of the resist layer 965 is made. In an embodiment, the exposure may be an angled patterning using a greyscale mask (not shown). As shown arrows 969 may be a high dose and arrow 968 may be a low dose. The high dose areas 967 are shown in a first shading, and the low dose area is shown with a second shading 966.

Referring now to Figure 9C, a cross-sectional illustration of the package substrate after a second exposure of the resist layer 965 is made. The exposure may be an angled patterning (in a direction opposite from the first patterning) using a greyscale mask. As shown, the second patterning overlays the first pattern to form a low dose region that is a trapezoidal shape. The high dose regions 967 have trapezoidal shapes with triangular notches of low dose regions 966 along a bottom surface. It is to be appreciated that the low dose region 966 may get a double exposure. However, so long as there is a sufficient delta between the high dose regions 967 and the low dose regions 966 then the subsequent developing processes will be able to be executed properly.

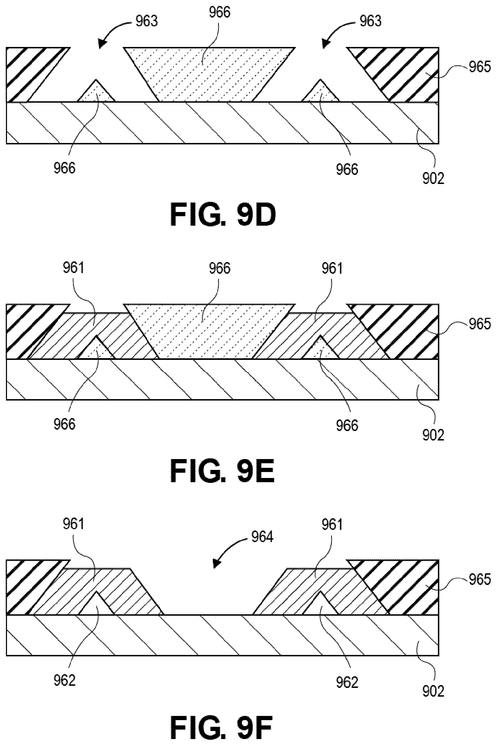

Referring now to Figure 9D, a cross-sectional illustration of the package substrate 902 after a first developing process is shown, in accordance with an embodiment. In an embodiment, the first developing process is a fast develop that only removes the high dose regions 967. As shown, openings 963 are provided between the unexposed regions of the resist layer 965 and the low dose regions 966.

Referring now to Figure 9E, a cross-sectional illustration of the package substrate 902 after a plating process is shown, in accordance with an embodiment. The plating may result in reflective structures 961 being formed in the openings 963. The reflective structures have a trapezoidal shaped cross-sections with a triangular notch in the bottom surfaces. In an embodiment, the reflective structures 961 may comprise copper or the like.

Referring now to Figure 9F, a cross-sectional illustration of the package substrate 902 after a second developing process is shown, in accordance with an embodiment. The second development process may be a longer develop in order to remove the low dose regions 966. Removal of the low dose regions 966 may result in the formation of a trench 964 between the reflective structures 961. In an embodiment, the notches 962 in the reflective structures 961 may be voids in some embodiments.

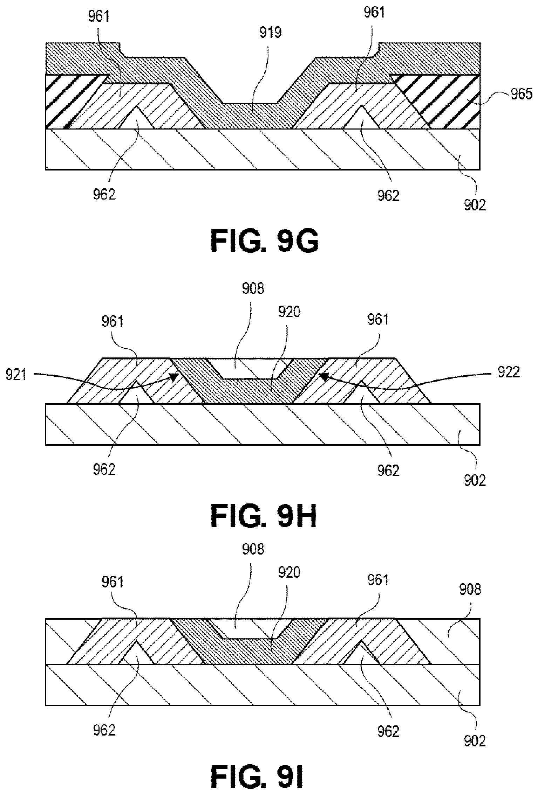

Referring now to Figure 9G, a cross-sectional illustration of the package substrate 902 after a high index of refraction material 919 is disposed is shown, in accordance with an embodiment. The high index of refraction material 919 may be deposited with a conformal deposition process, such as a spray coating or a sputtering process. In some embodiments, a hydrophobic treatment of the resist 965 may be made prior to deposition of the material 919 to prevent the material 919 from sticking to the resist 965. In an embodiment, the material 919 may be a high index polymer or dielectric.

Referring now to Figure 9H, a cross-sectional illustration of the package substrate 902 after a dielectric layer 908 is laminated and a planarization process is done is shown, in accordance with an embodiment. The dielectric layer 908 may be laminated over the material 919 and the planarization process recesses the dielectric layer 908 and the material 919 to expose the top surfaces of the reflective structures 961. The recessing results in the formation of the optical waveguide 920. The waveguide 920 comprises a first end 921 and a second end 922. The first end 921 and the second end 922 are adjacent and contacting the reflective structures 961. After the planarization process, the resist 965 may be stripped, as shown in Figure 9H.

Referring now to Figure 9I, a cross-sectional illustration of the package substrate 902 after an additional dielectric layer 908 is laminated is shown, in accordance with an embodiment. As shown, the dielectric layer 908 covers the edge surfaces of the reflective structures 961 opposite from the waveguide 920. In an embodiment, a planarization process may be used to expose the top surfaces of the reflective structures 961 after the dielectric layer 908 is laminated. In the illustrated embodiments, the notches 962 may be filled with dielectric material or the notches 962 may define a void in the package.

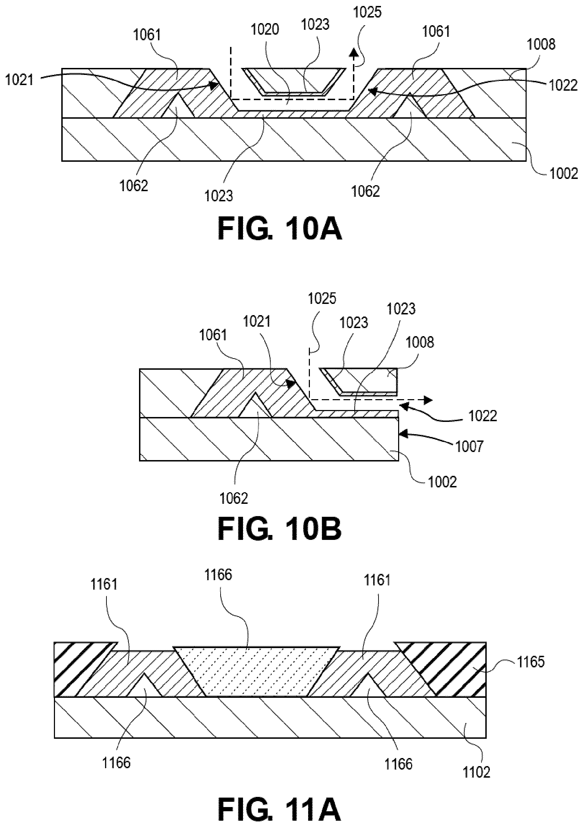

Referring now to Figure 10A, a cross-sectional illustration of an electronic package with a waveguide 1020 embedded in a package substrate 1002 is shown, in accordance with an embodiment. In this embodiment, the waveguide 1020 comprises a reflective cladding 1023. The reflective cladding 1023 may be copper or the like. In an embodiment, the waveguide 1020 may be air within the reflective cladding 1023. A first end 1021 of the waveguide 1020 may be adjacent to a reflective structure 1061, and the second end 1022 of the waveguide 1020 may be adjacent to a reflective structure 1061. The reflective structures 1061 have trapezoidal shaped cross-sections with a triangular notch 1062 formed in a bottom surface. In an embodiment, the reflective structures 1061 route an optical signal 1025 from within the waveguide 1020 up to overlying dies (not shown). In an embodiment, a dielectric layer 1008 may surround surfaces of the reflective structures 1061 opposite from the waveguide 1020.

Referring now to Figure 10B, a cross-sectional illustration of a waveguide 1020 is shown, in accordance with an additional embodiment. Instead of a pair of reflective structures 1061, only a single reflective structure 1061 is provided adjacent to the first end 1021. The second end 1022 of the waveguide 1020 is substantially coplanar with an edge 1007 of the package substrate 1002. While referred to as the second end 1022, it is to be appreciated that the waveguide 1020 may be air filled between the reflective cladding 1023, and that there may not be a solid surface at the second end 1022.

Referring now to Figures 11A-11F, a series of cross-sectional illustrations depicting a process for forming a waveguide in a package substrate is shown, in accordance with an embodiment. In this embodiment, the structure in Figure 11A may be formed using processing operations similar to those described above in Figures 9A-9E, and will not be repeated here.

Referring now to Figure 11A, a cross-sectional illustration of a structure for forming an embedded waveguide is shown, in accordance with an embodiment. The structure comprises a package substrate 1102 with a patterned resist layer 1165. At this point in the process flow, the high dose regions of the positive resist layer 1165 have been removed and reflective structures 1161 have been formed. The low dose regions 1166 of the positive resist layer 1165 remain at this point in the process flow.

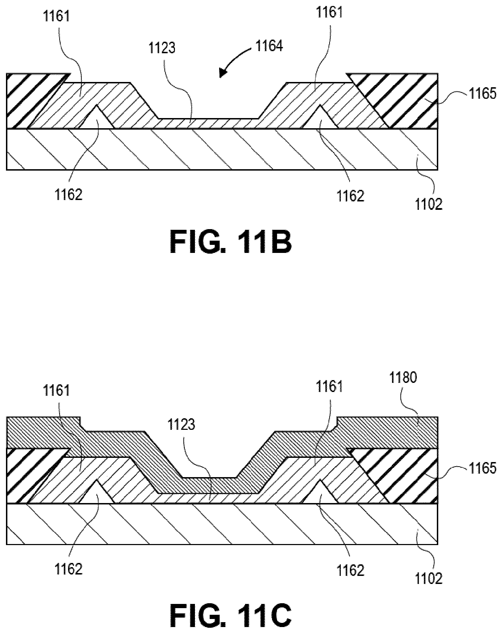

Referring now to Figure 11B, a cross-sectional illustration of the package substrate 1102 after the low dose regions 1166 are removed to form a trench 1164 and a portion of a reflective cladding 1123 is formed is shown, in accordance with an embodiment. Removal of the low dose regions 1166 may also form notches 1162 that are air voids in a bottom surface of the reflective structures 1161. The reflective cladding 1123 may form a bottom surface of the waveguide. The reflective cladding 1123 may comprise copper. Additionally, the reflective cladding 1123 may directly couple the two reflective structures 1161 together.

Referring now to Figure 11C, a cross-sectional illustration of the package substrate 1102 after a thermally decomposable layer 1180 is disposed over the exposed surfaces is shown, in accordance with an embodiment. In an embodiment, the thermally decomposable layer 1180 comprises a material that can be removed at elevated temperatures. In an embodiment, the thermally decomposable layer 1180 is deposited with a conformal process, such as a spray coating process.

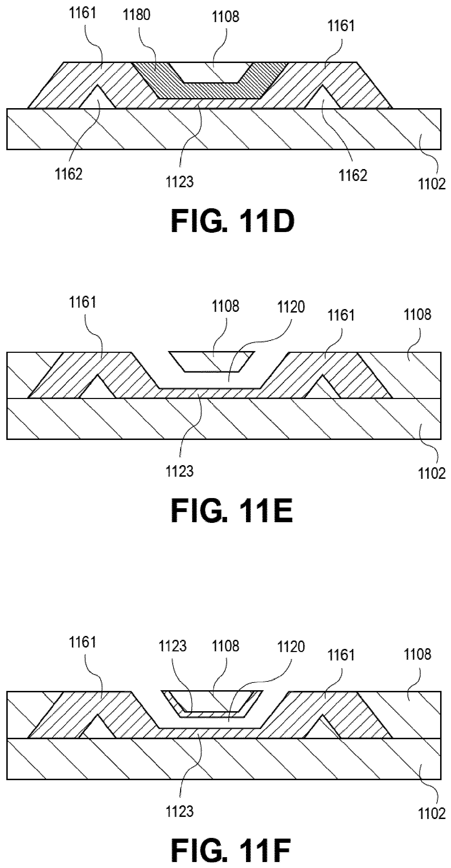

Referring now to Figure 11D, a cross-sectional illustration of the package substrate 1102 after a dielectric lamination and planarization process is shown, in accordance with an embodiment. In an embodiment, the dielectric layer 1108 is disposed over the thermally decomposable layer 1180. A planarization process may then be implemented to expose the top surfaces of the reflective structures 1161. After the planarization process, the resist layer 1165 may be stripped.

Referring now to Figure 11E, a cross-sectional illustration of the package substrate 1102 after an additional dielectric layer 1108 is laminated to cover the outside surfaces of the reflective structures 1161 and the thermally decomposable layer 1180 is removed is shown, in accordance with an embodiment. An additional planarization process may be done between the dielectric layer 1108 lamination and the removal of the thermally decomposable layer 1180. The removal of the thermally decomposable layer 1180 results in the formation of a void that is used as the waveguide 1120. As shown, a portion of the dielectric layer 1108 appears floating over the waveguide 1120. However, it is to be appreciated that the floating portion is supported out of the plane of Figure 11E.

Referring now to Figure 11F, a cross-sectional illustration of the package substrate 1102 after a top portion of the cladding 1123 is formed is shown, in accordance with an embodiment. In an embodiment, the top portion of the cladding 1123 over the floating portion of the dielectric 1108 may be done with an electroless plating process or the like. In some embodiments, the top portion of the cladding 1123 may be omitted. Additionally, a high index of refraction liquid material may be dispensed into the waveguide 1120 in some embodiments.

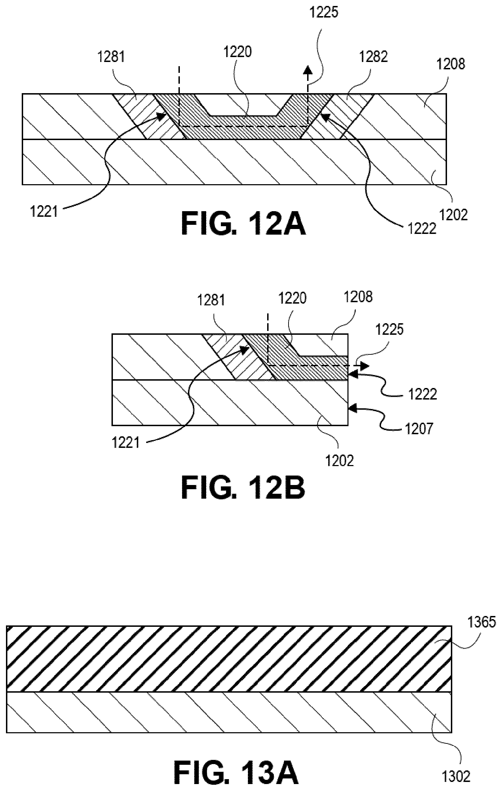

Referring now to Figure 12A, a cross-sectional illustration of an optical waveguide 1220 in a package substrate 1202 is shown, not in accordance with an embodiment. In this embodiment, the optical waveguide 1220 comprises a high index of refraction material, such as a high index polymer or dielectric. In this embodiment, the waveguide 1220 comprises a first end 1221 and a second end 1222. The first end 1221 and the second end 1222 are adjacent to reflective structures 1281 and 1282, respectively. The first structure 1281 is a mirror image of the second structure 1282. The reflective structures 1281 and 1282 reflect an optical signal 1225 that passes through the waveguide 1220 to overlying dies (not shown). In this embodiment, a dielectric layer 1208 embeds the waveguide 1220. The dielectric layer 1208 may be considered as part of the package substrate 1202 in some embodiment. not according to the claimed invention.

Referring now to Figure 12B, a cross-sectional illustration of a package substrate 1202 with a waveguide 1220 is shown, not in accordance with an additional embodiment. The waveguide 1220 is similar to the waveguide 1220 in Figure 12A, with the exception of the second end 1222 ending at an edge 1207 of the package substrate 1202. There is also no reflective structure 1282 at the second end 1222 of the waveguide 1220.

Referring now to Figures 13A-13H, a series of cross-sectional illustrations depicting a process for forming an embedded waveguide is shown, not in accordance with an embodiment.

Referring now to Figure 13A, a cross-sectional illustration of a package substrate 1302 is shown, not in accordance with an embodiment. A resist layer 1365 may be disposed over a top surface of the package substrate 1302.

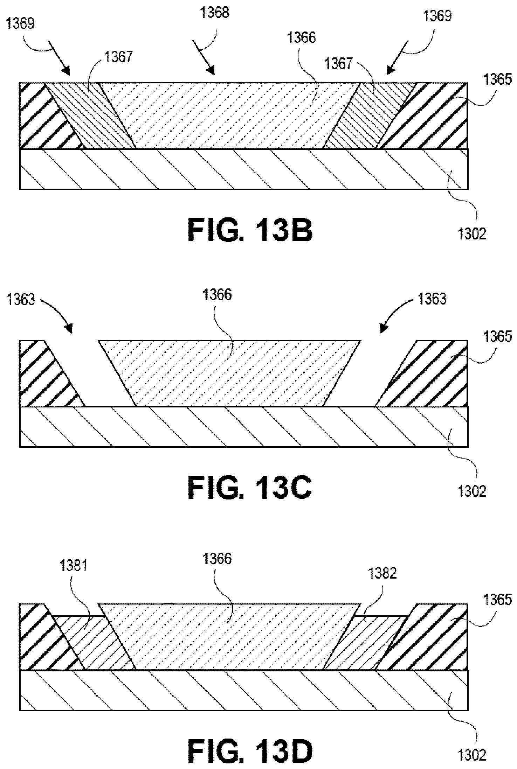

Referring now to Figure 13B, a cross-sectional illustration of the package substrate 1302 after the resist layer 1365 is exposed is shown, not in accordance with an embodiment. In an embodiment, the resist layer may be exposed using a two-photon-polymerization (2PP) variable exposure. This results in a low dose exposure 1368 and high dose exposures 1369. The low dose region 1366 may have a trapezoidal shape, and the high dose regions 1367 may have parallelogram shapes. The two high dose regions 1367 may be mirror images of each other. For a positive tone resist, such as diazoalkylquinone doped with a 2PP marker with a high 2P cross-section may be used to provide the 2PP variable exposure.

Referring now to Figure 13C, a cross-sectional illustration after the high dose regions 1367 are removed with a first developing process is shown, not in accordance with an embodiment. In this embodiment, the duration of the first developing process is short in order to ensure that none of the low dose region 1366 is removed. Removal of the high dose regions 1367 results in the formation of trenches 1363.

Referring now to Figure 13D, a cross-sectional illustration of the package substrate 1302 after reflective structures 1381 and 1382 are disposed in the trenches 1363 is shown, not in accordance with an embodiment. In this embodiment, the reflective structures 1381 and 1382 may comprise copper formed with any suitable plating process. The reflective structures 1381 and 1382 may be mirror images of each other, and have parallelogram shaped cross-sections.

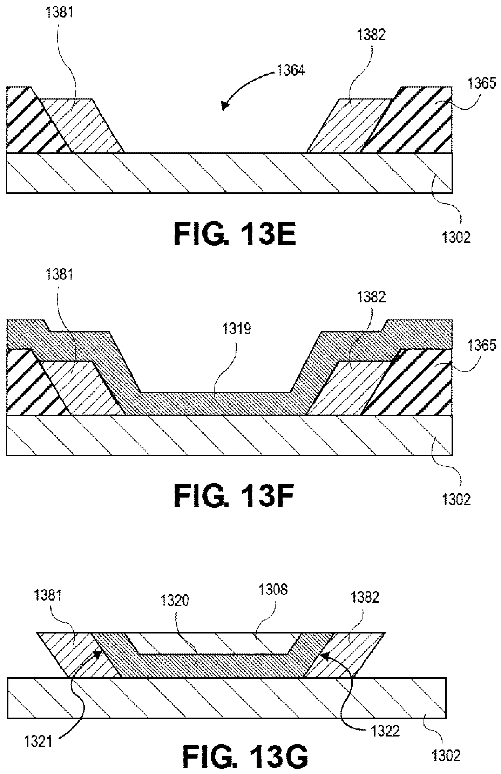

Referring now to Figure 13E, a cross-sectional illustration of the package substrate 1302 after the low dose region 1366 is removed is shown, not in accordance with an embodiment. Removal of the low dose region 1366 results in the formation of a trench 1364 between the reflective structures 1381 and 1382.

Referring now to Figure 13F, a cross-sectional illustration of the package substrate 1302 after a layer 1319 with a high index of refraction is disposed over the exposed surfaces is shown, not in accordance with an embodiment. In an embodiment, the layer 1319 may be conformally deposited (e.g., with a spray coating or sputtering process). In some embodiments, a hydrophobic treatment is applied to the resist layer 1365 to prevent deposition on the resist layer 1365.

Referring now to Figure 13G, a cross-sectional illustration of the package substrate 1302 after a dielectric layer 1308 is deposited and planarized is shown, not in accordance with an embodiment. In this embodiment, the planarization process exposes the top surfaces of the reflective structures 1381 and 1382. The planarization process also reduces the layer 1319 to form the waveguide 1320 between the reflective structures 1381 and 1382. The waveguide 1320 comprises a first end 1321 next to the reflective structure 1381 and a second end 1322 next to the reflective structure 1382. After the planarization process, the resist layer 1365 may be removed.

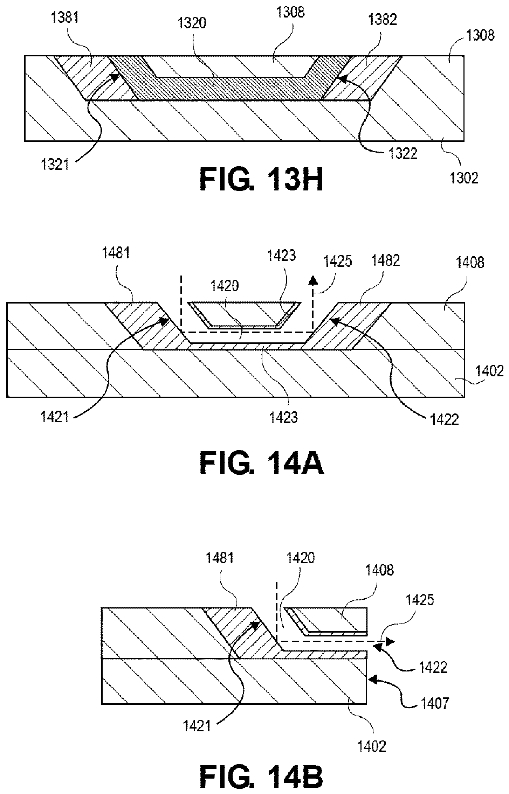

Referring now to Figure 13H, a cross-sectional illustration of the package substrate 1302 after an additional dielectric layer 1308 is laminated and planarized is shown, not in accordance with an embodiment. In an embodiment, the additional dielectric layer 1308 covers the sidewall surfaces of the reflective structures 1381 and 1382 opposite from the waveguide 1320.

Referring now to Figure 14A, a cross-sectional illustration of an embedded waveguide 1420 is shown, not in accordance with an embodiment. In an embodiment, the structure comprises a package substrate 1402. A pair of reflective structures 1481 and 1482 are provided over the package substrate 1402. The reflective structures 1481 and 1482 may be mirror images of each other and be connected together by a reflective cladding 1423. In this embodiment, a dielectric layer 1408 covers sidewall surfaces of the reflective structures 1481 and 1482.

In this embodiment, a portion of the dielectric layer 1408 may be above the waveguide 1420. The waveguide 1420 may comprise cladding layers 1423 and be air filled. The waveguide 1420 has a first end 1421 and a second end 1422. Optical signals 1425 propagate along the waveguide 1420 and reflect off of the reflective structures 1481 and 1482 to overlying dies (not shown).

Referring now to Figure 14B, a cross-sectional illustration of an embedded waveguide 1420 is shown, not in accordance with an additional embodiment. The waveguide 1420 in Figure 14B is similar to the waveguide in Figure 14A, with the exception of the second end 1422 ending at an edge 1407 of the package substrate 1402. That is, there is no second reflective structure 1482 in the embodiment shown in Figure 14B.

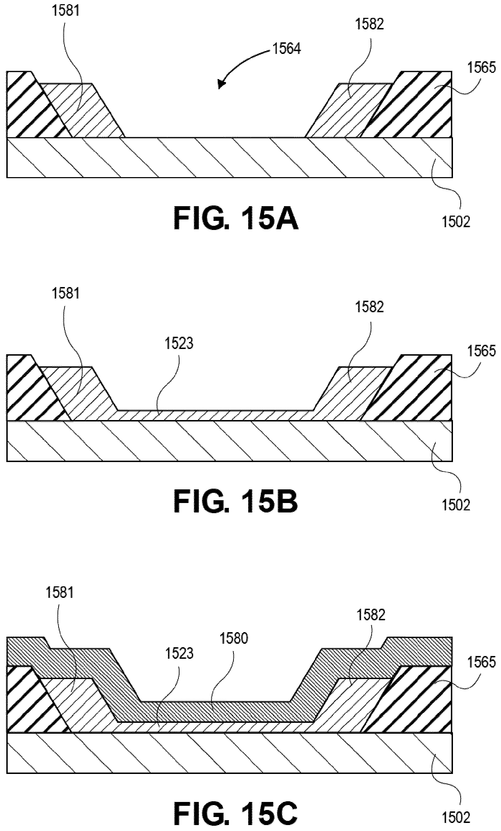

Referring now to Figures 15A-15F a series of cross-sectional illustrations depicting a process for forming an embedded waveguide is shown, not in accordance with an embodiment. The structure shown in Figure 15A may be fabricated using processing operations substantially similar to those described above with respect to Figures 13A-13E, and will not be repeated here.

Referring now to Figure 15A, a cross-sectional illustration of a package substrate 1502 with a patterned resist layer 1565 is shown, not in accordance with an embodiment. A trench 1564 may be formed in the patterned resist layer 1565. In this embodiment, a first reflective structure 1581 and a second reflective structure 1582 are formed at edges of the trench 1564. The reflective structures 1581 and 1582 may be mirror images of each other. For example, the reflective structures 1581 and 1582 may have parallelogram shaped cross-sections.

Referring now to Figure 15B, a cross-sectional illustration of the package substrate 1502 after a bottom cladding 1523 is disposed over the package substrate 1502 is shown, not in accordance with an embodiment. The bottom cladding 1523 may be copper or the like. The bottom cladding 1523 connects the first reflective structure 1581 to the second reflective structure 1582.

Referring now to Figure 15C, a cross-sectional illustration of the package substrate after a thermally decomposable layer 1580 is disposed over exposed surfaces is shown, not in accordance with an embodiment. The thermally decomposable layer 1580 may be a material that decomposes at elevated temperatures. In this embodiment, the thermally decomposable layer 1580 may be deposited with a spray coating process or the like.

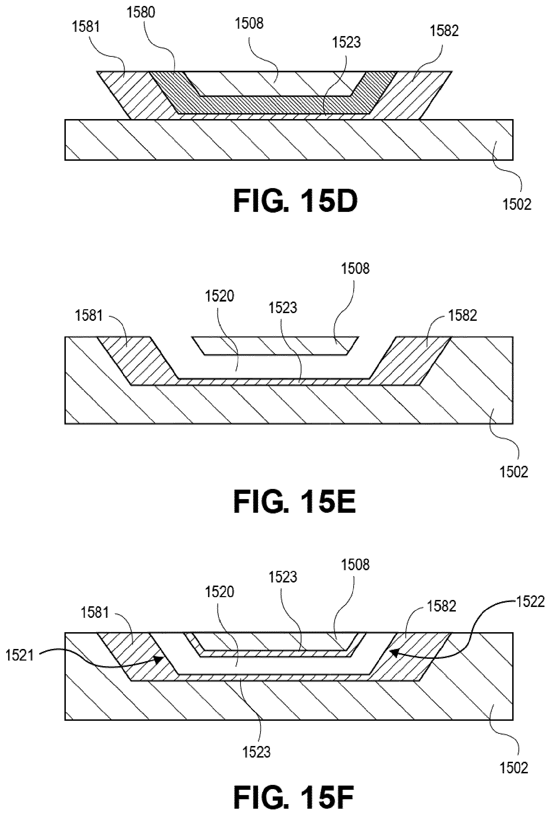

Referring now to Figure 15D, a cross-sectional illustration after a dielectric layer is laminated and a planarization process is implemented is shown, not in accordance with an embodiment. In an embodiment, the dielectric layer 1508 is disposed over the thermally decomposable layer 1580. The planarization process may be used to expose the top surfaces of the reflective structures 1581 and 1582. After the planarization process, the resist layer 1565 may be stripped.

Referring now to Figure 15E, a cross-sectional illustration of the package substrate 1502 after an additional dielectric layer 1508 is laminated to cover the outside surfaces of the reflective structures 1581 and 1582 and the thermally decomposable layer 1580 is removed is shown, in accordance with an embodiment. An additional planarization process may be done between the dielectric layer 1508 lamination and the removal of the thermally decomposable layer 1580. The removal of the thermally decomposable layer 1580 results in the formation of a void that is used as the waveguide 1520. As shown, a portion of the dielectric layer 1508 appears floating over the waveguide 1520. However, it is to be appreciated that the floating portion is supported out of the plane of Figure 15E.

Referring now to Figure 15F, a cross-sectional illustration of the package substrate 1502 after a top portion of the cladding 1523 is formed is shown, not in accordance with an embodiment. In this embodiment, the top portion of the cladding 1523 over the floating portion of the dielectric 1508 may be done with an electroless plating process or the like. In some embodiments, the top portion of the cladding 1523 may be omitted. Additionally, a high index of refraction liquid material may be dispensed into the waveguide 1520 in some embodiments. In this embodiment, the waveguide 1520 comprises a first end 1521 adjacent to the first reflective structure 1581 and a second end 1522 adjacent to the second reflective structure 1582.

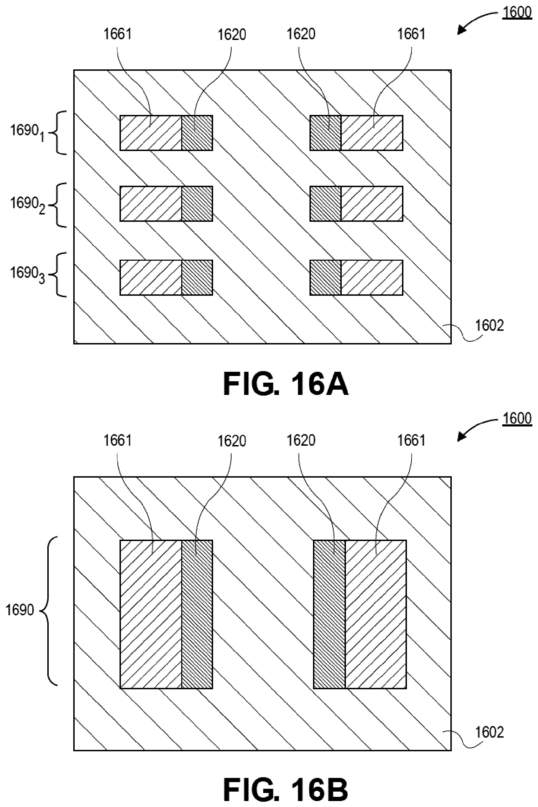

Referring now to Figure 16A, a plan view illustration of an electronic package 1600 is shown, not in accordance with an embodiment. As shown, an array of optical paths 1690₁₋₃ are provided across the surface of the package substrate 1602. While three optical paths 1690 are shown, it is to be appreciated that any number of optical paths 1690 may be used. In an embodiment, each of the optical paths 1690 comprises a pair of reflective structures 1661 and an optical waveguide 1620. The horizontal portion of the optical waveguide 1620 is below the surface of the package substrate 1602.

Referring now to Figure 16B, a plan view illustration of an electronic package 1600 is shown, not in accordance with an additional embodiment. In an embodiment, a waveguide plane 1690 is provided. The waveguide plane 1690 includes wider reflective structure 1661 and waveguide 1620. The extended width allows for multiple signals to be passed along the single waveguide plane 1690. Such an embodiment may be useful when light scattering within the waveguide 1620 is negligible.

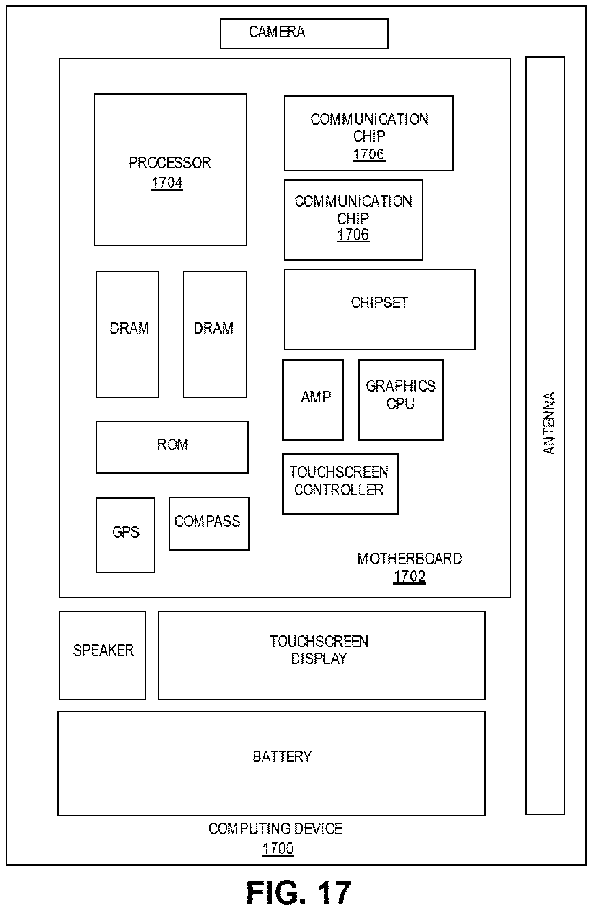

Figure 17 illustrates a computing device 1700 not in accordance with one implementation of the invention. The computing device 1700 houses a board 1702. The board 1702 may include a number of components, including but not limited to a processor 1704 and at least one communication chip 1706. The processor 1704 is physically and electrically coupled to the board 1702. In some implementations the at least one communication chip 1706 is also physically and electrically coupled to the board 1702. In further implementations, the communication chip 1706 is part of the processor 1704.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 1706 enables wireless communications for the transfer of data to and from the computing device 1700. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1706 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 1700 may include a plurality of communication chips 1706. For instance, a first communication chip 1706 may be dedicated to shorter range wireless communications such as Wi-Fi and Bluetooth and a second communication chip 1706 may be dedicated to longer range wireless communications such as GPS, EDGE, GPRS, CDMA, WiMAX, LTE, Ev-DO, and others.

The processor 1704 of the computing device 1700 includes an integrated circuit die packaged within the processor 1704. In some implementations of the invention, the integrated circuit die of the processor may be communicatively coupled to an additional die through a self-aligned optical waveguide. The term "processor" may refer to any device or portion of a device that processes electronic data from registers and/or memory to transform that electronic data into other electronic data that may be stored in registers and/or memory.

The communication chip 1706 also includes an integrated circuit die packaged within the communication chip 1706. In accordance with another implementation of the invention, the integrated circuit die of the communication chip may be communicatively coupled to an additional die through a self-aligned optical waveguide, in accordance with embodiments described herein.

The above description of illustrated implementations of the invention, including what is described in the Abstract, is not intended to be exhaustive or to limit the invention to the precise forms disclosed. While specific implementations of, and examples for, the invention are described herein for illustrative purposes, various equivalent modifications are possible within the scope of the invention, as those skilled in the relevant art will recognize. The invention is defined by the claims.

## Claims

1. An electronic package (100), comprising:
a package substrate (802);
a first die (110A) over the package substrate;
a second die (110B) over the package substrate; and
an optical waveguide (820) on the package substrate, wherein a first end (821) of the optical waveguide is below the first die and a second end (822) of the optical waveguide is below the second die, and wherein the optical waveguide communicatively couples the first die to the second die;
**characterized in that**
the electronic package further comprises a first reflective structure (861) at the first end (821) of the optical waveguide and a second reflective structure (861) at the second end (822) of the optical waveguide;
and **in that** the first reflective structure and the second reflective structure have trapezoidal cross-sections with a triangular notch (862) in a bottom surface.

2. The electronic package of claim 1, wherein the first end of the optical waveguide and the second end of the optical waveguide comprise sloped surfaces.

3. The electronic package (100) of claim 1 or 2, wherein the optical waveguide (820) comprises a material with an index of refraction greater than 1.0.

4. The electronic package (100) of claim 1, 2 or 3, wherein the optical waveguide (820) comprises air.

5. The electronic package (100) of claim 4, wherein the optical waveguide (820) comprises a reflective cladding around the air.

6. The electronic package (100) of claim 1, 2, 3, 4 or 5, wherein the optical waveguide (820) is above the package substrate (802).

7. The electronic package (100) of claim 1, 2, 3, 4, 5 or 6, wherein a top surface of the optical waveguide (820) contacts air or an index matching fluid or gel.

8. The electronic package (100) of claim 1, wherein the first reflective structure is connected to the second reflective structure by a reflective layer.

9. A method of fabricating an electronic package (100) of any of the preceding claims, the method comprising:
coupling a first die (110A) and a package substrate (802);
coupling a second die (110B) and the package substrate (802);
coupling an optical waveguide (820) and the package substrate (802), wherein a first end (821) of the optical waveguide is below the first die and a second end (822) of the optical waveguide is below the second die, and wherein the optical waveguide communicatively couples the first die to the second die; and
coupling a first reflective structure (861) at the first end (821) of the optical waveguide and a second reflective structure (861) at the second end (822) of the optical waveguide wherein the first reflective structure and the second reflective structure have trapezoidal cross-sections with a triangular notch (862) in a bottom surface.

10. The method of claim 9, wherein the first end of the optical waveguide and the second end of the optical waveguide comprise sloped surfaces.

11. The method of claim 9 or 10, wherein the optical waveguide (820) comprises a material with an index of refraction greater than 1.0.

12. The method of claim 9, 10 or 11, wherein the optical waveguide (820) comprises air.

13. The method of claim 12, wherein the optical waveguide (820) comprises a reflective cladding around the air.

## Patentansprüche

1. Elektronikgehäuse (100), das Folgendes umfasst:
ein Gehäusesubstrat (802);
einen ersten Die (110A), der mit dem Gehäusesubstrat gekoppelt ist;
einen zweiten Die (110B), der mit dem Gehäusesubstrat gekoppelt ist; und
einen optischen Wellenleiter (820) auf dem Gehäusesubstrat, wobei ein erstes Ende (821) des optischen Wellenleiters unter dem ersten Die liegt und ein zweites Ende (822) des optischen Wellenleiters unter dem zweiten Die liegt, und wobei der optische Wellenleiter den ersten Die kommunikativ mit dem zweiten Die koppelt;
**dadurch gekennzeichnet, dass** das Elektronikgehäuse ferner eine erste reflektierende Struktur (861) am ersten Ende (821) des optischen Wellenleiters und eine zweite reflektierende Struktur (861) am zweiten Ende (822) des optischen Wellenleiters umfasst;
und dass die erste reflektierende Struktur und die zweite reflektierende Struktur trapezförmige Querschnitte mit einer dreieckigen Kerbe (862) in einer unteren Oberfläche aufweisen.

2. Elektronikgehäuse nach Anspruch 1, wobei das erste Ende des optischen Wellenleiters und das zweite Ende des optischen Wellenleiters geneigte Oberflächen umfassen.

3. Elektronikgehäuse (100) nach Anspruch 1 oder 2, wobei der optische Wellenleiter (820) ein Material mit einem Brechungsindex größer als 1,0 umfasst.

4. Elektronikgehäuse (100) nach Anspruch 1, 2 oder 3, wobei der optische Wellenleiter (820) Luft umfasst.

5. Elektronikgehäuse (100) nach Anspruch 4, wobei der optische Wellenleiter (820) eine reflektierende Verkleidung um die Luft umfasst.

6. Elektronikgehäuse (100) nach Anspruch 1, 2, 3, 4 oder 5, wobei der optische Wellenleiter (820) über dem Gehäusesubstrat (802) liegt.

7. Elektronikgehäuse (100) nach Anspruch 1, 2, 3, 4, 5 oder 6, wobei eine obere Oberfläche des optischen Wellenleiters (820) Luft oder ein Indexanpassungsfluid oder -gel kontaktiert.

8. Elektronikgehäuse (100) nach Anspruch 1, wobei die erste reflektierende Struktur mit der zweiten reflektierenden Struktur durch eine reflektierende Schicht verbunden ist.

9. Verfahren zum Fertigen eines Elektronikgehäuses (100) nach einem der vorstehenden Ansprüche, wobei das Verfahren Folgendes umfasst:
Koppeln eines ersten Die (110A) und eines Gehäusesubstrats (802);
Koppeln eines zweiten Die (110B) und des Gehäusesubstrats (802) ;
Koppeln eines optischen Wellenleiters (820) und des Gehäusesubstrats (802), wobei ein erstes Ende (821) des optischen Wellenleiters unter dem ersten Die liegt und ein zweites Ende (822) des optischen Wellenleiters unter dem zweiten Die liegt, und wobei der optische Wellenleiter den ersten Die kommunikativ mit dem zweiten Die koppelt; und
Koppeln einer ersten reflektierenden Struktur (861) am ersten Ende (821) des optischen Wellenleiters und einer zweiten reflektierenden Struktur (861) am zweiten Ende (822) des optischen Wellenleiters, wobei die erste reflektierende Struktur und die zweite reflektierende Struktur trapezförmige Querschnitte mit einer dreieckigen Kerbe (862) in einer unteren Oberfläche aufweisen.

10. Verfahren nach Anspruch 9, wobei das erste Ende des optischen Wellenleiters und das zweite Ende des optischen Wellenleiters geneigte Oberflächen umfassen.

11. Verfahren nach Anspruch 9 oder 10, wobei der optische Wellenleiter (820) ein Material mit einem Brechungsindex größer als 1,0 umfasst.

12. Verfahren nach Anspruch 9, 10 oder 11, wobei der optische Wellenleiter (820) Luft umfasst.

13. Verfahren nach Anspruch 12, wobei der optische Wellenleiter (820) eine reflektierende
Verkleidung um die Luft umfasst.

## Revendications

1. Boîtier électronique (100), comprenant :
un substrat (802) de boîtier ;
un premier die (110A) par-dessus le substrat de boîtier ;
un deuxième die (110B) par-dessus le substrat de boîtier ; et
un guide d'onde optique (820) sur le substrat de boîtier, une première extrémité (821) du guide d'onde optique étant située au-dessous du premier die et une deuxième extrémité (822) du guide d'onde optique étant située au-dessous du deuxième die, et le guide d'onde optique couplant de manière communicante le premier die au deuxième die ;
le boîtier électronique étant **caractérisé en ce qu'**il comprend en outre une première structure réfléchissante (861) à la première extrémité (821) du guide d'onde optique et une deuxième structure réfléchissante (861) à la deuxième extrémité (822) du guide d'onde optique ;
et **en ce que** la première structure réfléchissante et la deuxième structure réfléchissante présentent des sections transversales trapézoïdales avec une encoche triangulaire (862) dans une surface inférieure.

2. Boîtier électronique selon la revendication 1, dans lequel la première extrémité du guide d'onde optique et la deuxième extrémité du guide d'onde optique comprennent des surfaces inclinées.

3. Boîtier électronique (100) selon la revendication 1 ou 2, dans lequel le guide d'onde optique (820) comprend un matériau dont l'indice de réfraction est supérieur à 1,0.

4. Boîtier électronique (100) selon la revendication 1, 2, ou 3, dans lequel le guide d'onde optique (820) comprend de l'air.

5. Boîtier électronique (100) selon la revendication 4, dans lequel le guide d'onde optique (820) comprend un revêtement réfléchissant autour de l'air.

6. Boîtier électronique (100) selon la revendication 1, 2, 3, 4 ou 5, dans lequel le guide d'onde optique (820) se situe au-dessus du substrat (802) de boîtier.

7. Boîtier électronique (100) selon la revendication 1, 2, 3, 4, 5 ou 6, dans lequel une surface supérieure du guide d'onde optique (820) entre en contact avec l'air ou avec un fluide ou un gel adaptateur d'indice.

8. Boîtier électronique (100) selon la revendication 1, dans lequel la première structure réfléchissante est connectée à la deuxième structure réfléchissante par une couche réfléchissante.

9. Procédé de fabrication d'un boîtier électronique (100) selon l'une quelconque des revendications précédentes, le procédé comprenant :
le couplage d'un premier die (110A) et d'un substrat (802) de boîtier ;
le couplage d'un deuxième die (110B) et du substrat (802) de boîtier ;
le couplage d'un guide d'onde optique (820) et du substrat (802) de boîtier, une première extrémité (821) du guide d'onde optique étant située au-dessous du premier die et une deuxième extrémité (822) du guide d'onde optique étant située au-dessous du deuxième die, et le guide d'onde optique couplant de manière communicante le premier die au deuxième die ; et
le couplage d'une première structure réfléchissante (861) à la première extrémité (821) du guide d'onde optique et d'une deuxième structure réfléchissante (861) à la deuxième extrémité (822) du guide d'onde optique, la première structure réfléchissante et la deuxième structure réfléchissante présentant des sections transversales trapézoïdales avec une encoche triangulaire (862) dans une surface inférieure.

10. Procédé selon la revendication 9, dans lequel la première extrémité du guide d'onde optique et la deuxième extrémité du guide d'onde optique comprennent des surfaces inclinées.

11. Procédé selon la revendication 9 ou 10, dans lequel le guide d'onde optique (820) comprend un matériau dont l'indice de réfraction est supérieur à 1,0.

12. Procédé selon la revendication 9, 10, ou 11, dans lequel le guide d'onde optique (820) comprend de l'air.

13. Procédé selon la revendication 12, dans lequel le guide d'onde optique (820) comprend un revêtement réfléchissant autour de l'air.
